# EUROPÄISCHE PATENTSCHRIFT

(11) **EP 3 008 737 B1**
(45) Veröffentlichungstag und Bekanntmachung des Hinweises auf die Patenterteilung: **13.03.2019**
(21) Anmeldenummer: 14733986.5
(22) Anmeldetag: 28.05.2014
(51) Int. Cl.: H01C 1/14, H01C 7/00, H01C 17/00, H01C 17/28, G01R 1/20, H01C 7/06, H01C 1/144, G01R 27/08, G01R 3/00

(54) **STANZTEIL ZUR HERSTELLUNG EINES ELEKTRISCHEN WIDERSTANDS, STROMSENSOR UND ENTSPRECHENDES HERSTELLUNGSVERFAHREN**
STAMPING PART FOR PRODUCTION OF AN ELECTRIC RESISTANCE, CURRENT SENSOR AND METHOD OF ITS PRODUCTION
BANDE MÉTALLIQUE POUR LA PRODUCTION DE RÉSISTANCE ÉLECTRIQUE, CAPTEUR DE COURANT ET SA RÉALISATION

(30) Priorität: 10.06.2013 DE 102013009726
(43) Veröffentlichungstag der Anmeldung: 20.04.2016
(73) Patentinhaber: Isabellenhütte Heusler GmbH & Co. KG, 35683 Dillenburg (DE)
(72) Erfinder: MARIEN, Jan, 35745 Herborn (DE)
(74) Vertreter: v. Bezold & Partner Patentanwälte - PartG mbB
(86) Internationale Anmeldenummer: PCT/EP2014/001456
(87) Internationale Veröffentlichungsnummer: WO 2014/198382

(56) Entgegenhaltungen:
- EP-B1- 1 252 526
- WO-A2-96/18109
- DE-A1-102010 009 835
- DE-U1- 20 117 650
- US-A- 5 999 085

## Beschreibung

Die Erfindung betrifft ein Stanzteil zur Herstellung eines elektrischen Widerstands, insbesondere eines Strommesswiderstands. Weiterhin betrifft die Erfindung einen Stromsensor mit einem solchen Stanzteil und ein geeignetes Herstellungsverfahren.

Es ist bereits seit Längerem bekannt, elektrische Ströme mittels eines niederohmigen Strommesswiderstands ("Shunt") gemäß der sogenannten Vierleitertechnik zu messen. Dabei wird der zu messende elektrische Strom durch den Strommesswiderstand geleitet, wobei die über dem Strommesswiderstand abfallende elektrische Spannung gemessen wird. Die gemessene Spannung ist dem zu messenden Strom proportional und bildet somit ein Maß für den elektrischen Strom.

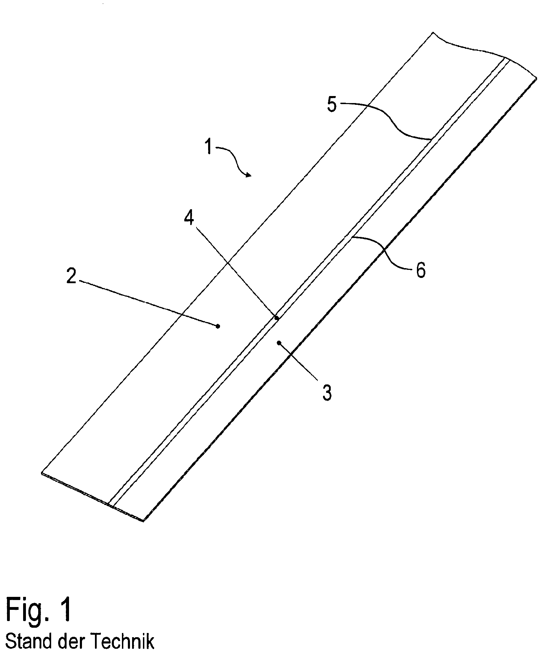

Aus EP 0 605 800 A1 ist es bekannt, einen solchen Strommesswiderstand aus einem Verbundmaterialband 1 herzustellen, wie es beispielhaft in Figur 1 dargestellt ist. So besteht das Verbundmaterial 1 aus zwei Bändern 2, 3 aus einem Leitermaterial (z.B. Kupfer) und einem Band 4 aus einem Widerstandsmaterial (z.B. CuMnNi-Legierung), wobei das Band 4 aus dem Widerstandsmaterial zwischen den beiden Bändern 2, 3 aus dem Leitermaterial angeordnet ist und entlang seiner Längskanten 5, 6 mit den Bändern 2, 3 aus dem Leitermaterial verschweißt ist. Bei der Herstellung der Strommesswiderstände aus dem Verbundmaterialband 1 werden dann jeweils Stanzteile quer zur Bandlängsrichtung aus dem Verbundmaterial 1 ausgestanzt, wobei jedes Stanzteil dann einen Strommesswiderstand bildet. Die bekannten Stanzteile gemäß EP 0 605 800 A1 weisen also nur zwei Stromanschlussteile zur Einleitung bzw. Ausleitung des elektrischen Stroms und ein Widerstandselement auf, das in Stromflussrichtung zwischen den beiden Stromanschlussteilen angeordnet ist und deshalb von dem zu messenden elektrischen Strom durchflossen wird.

Die Messung der über dem Strommesswiderstand abfallenden elektrischen Spannung erfolgt dann in der Regel durch eine integrierte Schaltung (ASIC: Application specific integrated circuit), wie sie beispielsweise aus EP 1 363 131 A1 bekannt ist. Die zur Spannungsmessung eingesetzte integrierte Schaltung ist in der Regel über Lötverbindungen mittels einer Leiterkarte mit dem Strommesswiderstand verbunden, was zu verschiedenen Nachteilen führt.

Zum einen werden die integrierte Schaltung und der Strommesswiderstand in der Regel separat in einem Gehäuse verpackt, so dass doppelter Verpackungsaufwand entsteht.

Zum anderen können die Kennlinien des Widerstands und der integrierten Schaltung erst im Zusammenspiel auf der Leiterkarte abgeglichen werden.

Ferner bestehen zwischen der Eingangsstufe des Eingangsverstärkers der integrierten Schaltung und dem Spannungsabgriff des Strommesswiderstands Lötverbindungen, Durchkontaktierungen und Leiterbahnführungen auf der Leiterkarte, die zu unerwünschten parasitären Effekten (z.B. Thermospannungen, Induktionsschleifen, Übersprechen anderer Signale) führen können.

Es ist deshalb wünschenswert, den Strommesswiderstand und die integrierte Schaltung zur Spannungsmessung in einem gemeinsamen Gehäuse zu integrieren. Ein Ansatz hierfür ist aus US 2010/0001382 A1 bekannt, jedoch sind hierbei zusätzliche Arbeitsschritte erforderlich, die in heutigen Standardherstellungsverfahren nicht etabliert sind.

Weiterhin ist zum Stand der Technik hinzuweisen auf US 5 534 788 A, DE 10 2006 039 722 A1, DE 10 2009 031 408 A1, DE 42 43 349 A1, DE 10 2011 113 002 A1, US 5 999 085, EP 1 252 526 A1 und DE 102 37 126 A1.

Schließlich offenbart DE 601 28 510 T2 ein Stanzteil mit einer Landefläche zur Bestückung mit einer integrierten Schaltung. Das Stanzteil besteht hierbei jedoch aus einem einheitlichen Material und eignet sich deshalb nicht für einen Präzisionsmesswiderstand. Bei einem Präzisionsmesswiderstand müssen das eigentliche Widerstandselement einerseits und die Anschlussteile andererseits nämlich aus unterschiedlichen Materialien bestehen. Beispielsweise kann das Widerstandselement aus einer Kupfer-Mangan-Nickel-Legierung bestehen, während die Anschlussteile aus Kupfer oder einer Kupferlegierung bestehen. Das Stanzteil gemäß DE 601 28 510 T2 eignet sich also nicht für einen Präzisionsmesswiderstand. Eine ähnliche Widerstandsanordnung ist auch aus WO 96/18109 A2 bekannt. Schließlich ist zum allgemeinen technologischen Hintergrund noch hinzuweisen auf DE 10 2010 009 835 A1 und DE 201 17 650 U1.

Der Erfindung liegt deshalb die Aufgabe zugrunde, eine verbesserte Möglichkeit zur Integration eines Strommesswiderstands mit einer Auswertungsschaltung zu schaffen.

Diese Aufgabe wird durch ein Stanzteil, einen Stromsensor mit einem solchen Stanzteil und ein entsprechendes Herstellungsverfahren gemäß den Ansprüchen gelöst.

Die Erfindung umfasst die allgemeine technische Lehre, den Strommesswiderstand aus einem Stanzteil aus einem Verbundmaterialband herzustellen, wobei das Stanzteil nicht nur - wie bei dem bekannten Verfahren gemäß EP 0 605 800 A1 - die Stromanschlussteile und das Widerstandselement enthält, sondern zusätzlich auch eine Landefläche zur Bestückung mit einer integrierten Schaltung auf der Landefläche des Stanzteils. Der im Rahmen der Erfindung verwendete Begriff einer Landefläche bedeutet, dass auf der Landefläche des Stanzteils später eine integrierte Schaltung angeordnet werden kann, die zur Spannungsmessung dient. Die zur Spannungsmessung dienende integrierte Schaltung befindet sich dann vorteilhaft in unmittelbarer Nähe des Strommesswiderstands. Hierbei ist zu erwähnen, dass der Begriff einer Landefläche daher rührt, dass die integrierte Schaltung bei der Bestückung von oben zugeführt wird und dann quasi auf der Landefläche des Stanzteils landet.

Die Erfindung sieht deshalb zunächst ein Stanzteil vor, aus dem dann ein elektrischer Widerstand (z.B. Strommesswiderstand) hergestellt werden kann. In Übereinstimmung mit dem aus EP 0 605 800 A1 bekannten Stanzteil weist das erfindungsgemäße Stanzteil zunächst ein Widerstandselement aus einem niederohmigen Widerstandsmaterial (z.B. MANGANIN®) auf.

Darüber hinaus umfasst das erfindungsgemäße Stanzteil in Übereinstimmung mit dem bekannten Stanzteil gemäß EP 0 605 800 A1 zwei Stromanschlussteile auf, die aus einem Leitermaterial (z.B. Kupfer) bestehen und die Aufgabe haben, den elektrischen Strom in den Widerstand einzuleiten bzw. auszuleiten.

Das Widerstandselement ist hierbei in Stromflussrichtung zwischen den beiden Anschlussteilen angeordnet, so dass der elektrische Strom durch das Widerstandselement fließt.

In dem bevorzugten Ausführungsbeispiel der Erfindung sind die beiden Stromanschlussteile hierbei beabstandet zueinander auf derselben Seite des Widerstandselements angeordnet. Es besteht jedoch grundsätzlich auch die Möglichkeit, dass die beiden Stromanschlussteile auf gegenüberliegenden Seiten des Widerstandselements angeordnet sind.
Das erfindungsgemäße Stanzteil zeichnet sich nun gegenüber dem aus EP 0 605 800 A1 bekannten Stanzteil dadurch aus, dass das Stanzteil zusätzlich eine Landefläche zur Bestückung mit einer integrierten Schaltung aufweist.
Der im Rahmen der Erfindung verwendete Begriff eines Stanzteils bedeutet Rohlinge, die noch nicht vereinzelt sind und zur Herstellung einer Vielzahl von Widerständen dienen, wozu die einzelnen Widerstände lediglich aus dem Rohling abgetrennt werden müssen.

Gemäß der Erfindung, nach Anspruch 1, weist das Stanzteil zwei Spannungsmesskontakte auf, um die über dem Widerstandselement des Widerstands abfallende elektrische Spannung zu messen. Die Stanzgeometrie ist also hierbei so ausgelegt, dass beim Stanzvorgang nicht nur die Stromanschlussteile, das Widerstandselement und die Landefläche für die integrierte Schaltung gebildet werden, sondern auch die beiden Spannungsmesskontakte zur Spannungsmessung entsprechend der bekannten Vierleitertechnik.
Darüber hinaus umfasst das Stanzteil in dem bevorzugten Ausführungsbeispiel der Erfindung auch mehrere elektrische Außenkontakte zur elektrischen Kontaktierung der integrierten Schaltung von außen. Beim Ausstanzen des erfindungsgemäßen Stanzteils werden also vorzugsweise auch gleich die Außenkontakte zur elektrischen Kontaktierung der integrierten Schaltung hergestellt.

Hierbei ist zu erwähnen, dass die Außenkontakte durch eine Ausstanzung von der Landefläche für die integrierte Schaltung und/oder von den Spannungsmesskontakten getrennt sind. Dies ist wichtig, damit es zu keinem Kurzschluss zwischen den einzelnen Außenkontakten einerseits und der Landefläche bzw. den Spannungsmesskontakten andererseits kommt.

Weiterhin ist zu erwähnen, dass die Spannungsmesskontakte einerseits und die Stromanschlussteile andererseits vorzugsweise auf gegenüberliegenden Seiten des Widerstandselements angeordnet sind. Der zu messende elektrische Strom wird also an einer Seite des Widerstandselements eingeleitet bzw. ausgeleitet, wohingegen die Spannungsmessung mittels der Spannungsmesskontakte an der gegenüberliegenden Seite des Widerstandselements erfolgt.

Es wurde bereits vorstehend erwähnt, dass die beiden Stromanschlussteile bezüglich der Stromflussrichtung in dem Widerstandselement seitlich an das Widerstandselement angrenzen können, insbesondere auf derselben Seite des Widerstandselements. Dies erleichtert das Ausstanzen aus einem herkömmlichen Verbundmaterialband, wie es beispielsweise in Figur 1 dargestellt ist. Das eine Band aus dem Leitermaterial (z.B. Kupfer) bildet dann die beiden Stromanschlussteile, während das gegenüberliegende Band aus dem Leitermaterial die Spannungsmesskontakte, die Landefläche für die integrierte Schaltung und die Außenkontakte für die integrierte Schaltung bildet.

In dem bevorzugten Ausführungsbeispiel der Erfindung handelt es sich bei dem Leitermaterial um Kupfer oder eine Kupferlegierung, jedoch ist die Erfindung nicht auf diese Materialien beschränkt. Entscheidend ist lediglich, dass das Leitermaterial eine hinreichend große elektrische Leitfähigkeit aufweist.

Bei dem Widerstandsmaterial des Widerstandselements handelt es sich dagegen vorzugsweise um eine Kupferlegierung, wie beispielsweise eine Kupfer-Mangan-Nickel-Legierung, wobei vorzugsweise Cu84Ni4Mn12 eingesetzt werden kann. Alternativ besteht jedoch die Möglichkeit, dass es sich bei dem Widerstandsmaterial des Widerstandselements um eine Nickellegierung handelt, insbesondere NiCr oder CuNi. Die Erfindung ist jedoch hinsichtlich des Widerstandsmaterials nicht auf die vorstehend genannten Beispiele beschränkt, sondern grundsätzlich auch mit anderen Materialien realisierbar. Allerdings sollte der spezifische elektrische Widerstand des Leitermaterials kleiner sein als der spezifische elektrische Widerstand des Widerstandsmaterials.

Darüber hinaus sollte das Widerstandsmaterial einen spezifischen elektrischen Widerstand mit einem möglichst kleinen Temperaturkoeffizienten aufweisen, wobei der Temperaturkoeffizient vorzugsweise kleiner ist als 5·10⁻⁴K⁻¹, 2·10⁻⁴K⁻¹, 1·10⁻⁴K⁻¹ oder 5·10⁻⁵K⁻¹.

Der spezifische elektrische Widerstand des Widerstandsmaterials ist in dem bevorzugten Ausführungsbeispiel der Erfindung kleiner als 2·10⁻⁴ Ω·m, 2·10⁻⁵ Ω·m oder 2·10⁻⁶ Ω·m.

Das Leitermaterial weist dagegen vorzugsweise einen spezifischen elektrischen Widerstand auf, der kleiner ist als 2·10⁻⁵ Ω·m, 2·10⁻⁶ Ω·m oder 2·10⁻⁷ Ω·m.

Weiterhin ist zu erwähnen, dass das Widerstandselement in dem bevorzugten Ausführungsbeispiel elektrisch und mechanisch mit den beiden Stromanschlussteilen verbunden ist, insbesondere durch eine Schweißverbindung. Besonders vorteilhaft ist es hierbei, wenn die einzelnen Bänder des Verbundmaterialbands durch eine Elektronenstrahlverschweißung miteinander verbunden sind, so dass dann auch das Widerstandselement und die Stromanschlussteile durch eine Elektronenstrahlverschweißung miteinander verbunden sind.

In dem bevorzugten Ausführungsbeispiel der Erfindung sind die Stromanschlussteile und das Widerstandselement plattenförmig, was an sich aus dem eingangs zitierten Stand der Technik bekannt ist. Der im Rahmen der Erfindung verwendete Begriff eines plattenförmigen Widerstandselements bzw. plattenförmiger Stromanschlussteile umfasst sowohl ebene Gestaltungen als auch gebogene Gestaltungen.

Darüber hinaus beansprucht die Erfindung nicht nur Schutz für das vorstehend beschriebene erfindungsgemäße Stanzteil, sondern betrifft auch einen Stromsensor, der ein solches Stanzteil enthält.

Weiterhin umfasst der erfindungsgemäße Stromsensor in dem bevorzugten Ausführungsbeispiel auch eine integrierte Schaltung, die auf der Landefläche des Stanzteils montiert ist und zur Spannungsmessung dient. Beispielsweise kann es sich hierbei um eine integrierte Schaltung handeln, wie sie aus EP 1 363 131 A1 bekannt ist.

In einem bevorzugten Ausführungsbeispiel der Erfindung umfasst der Stromsensor zwei integrierte Schaltungen, die eine Eingangsstufe bzw. eine Ausgangsstufe bilden und vorzugsweise galvanisch getrennt sind, beispielsweise durch eine kapazitive, induktive oder optische Kopplung.

Die Eingangsstufe ist hierbei durch Bondverbindungen mit den Spannungsmesskontakten verbunden, um die über dem Widerstandselement abfallende elektrische Spannung zu messen.

Die Ausgangsstufe gibt dagegen ein Ausgangssignal aus, das die über dem Widerstandselement abfallende elektrische Spannung wiedergibt, insbesondere in digitaler Form. Vorzugsweise enthält die Ausgangsschaltung einen Sigma-Delta-Modulator, der als Ausgangssignal einen 1-Bit-Datenstrom ausgibt, was an sich aus EP 1 363 131 A1 bekannt ist.

Es besteht jedoch auch die Möglichkeit, dass das Ausgangssignal eine analoge Ausgangsspannung ist, die der über dem Widerstandselement abfallenden elektrischen Spannung proportional ist.

Ferner besteht die Möglichkeit, dass das Ausgangssignal ein elektrischer Strom ist, der der über dem Widerstandselement abfallenden elektrischen Spannung proportional ist.

In dem bevorzugten Ausführungsbeispiel der Erfindung ist die integrierte Schaltung durch Bondverbindungen auch mit den Außenkontakten und/oder mit den Spannungsmesskontakten verbunden. Die Herstellung der Bondverbindungen erfolgt hierbei nach dem Ausstanzen des Stanzteils und nach dem Aufsetzen der integrierten Schaltung auf der Landefläche des Stanzteils.

In dem bevorzugten Ausführungsbeispiel der Erfindung weist der fertige Stromsensor eine elektrisch isolierende Ummantelung auf, welche die integrierte Schaltung, die Bondverbindungen und den Widerstand umgibt, wobei die Außenkontakte der integrierten Schaltung und die Stromanschlussteile des Widerstands aus der Ummantelung herausragen.

Vorzugsweise besteht diese Ummantelung aus einem Kunststoff, wie beispielsweise einem Duroplast, was sich als vorteilhaft erwiesen hat. So kann die Ummantelung beispielsweise hergestellt werden, indem die integrierte Schaltung, die Bondverbindung und der Widerstand mit dem Kunststoff (z.B. Duroplast) umspritzt werden.

Weiterhin ist zu erwähnen, dass der erfindungsgemäße Stromsensor mehrere Widerstandselemente enthalten kann, um mehrere elektrische Ströme messen zu können. Ein Einsatzgebiet eines solchen Stromsensors mit mehreren Widerstandselementen besteht in der mehrphasigen Strommessung in einem Wechselstrom-Mehrphasennetz. Ein anderes Einsatzgebiet eines solchen Stromsensors mit mehreren Widerstandselementen besteht in einer Differenzstrommessung, wie sie beispielsweise in DE 10 2011 113 002 A1 beschrieben ist.

Schließlich umfasst die Erfindung auch ein entsprechendes Herstellungsverfahren zur Herstellung eines Stromsensors, was sich teilweise bereits aus der vorstehenden Beschreibung ergibt.

In Übereinstimmung mit dem eingangs beschriebenen bekannten Herstellungsverfahren gemäß EP 0605 800 A1 sieht das erfindungsgemäße Herstellungsverfahren zunächst vor, dass ein Verbundmaterialband bereitgestellt wird, das zwei äußere Bänder aus einem Leitermaterial (z.B. Kupfer) und ein mittleres Band aus einem Widerstandsmaterial (z.B. MANGANIN®) aufweist, wobei die Bänder entlang ihrer Längskanten elektrisch und mechanisch miteinander verbunden sind, insbesondere durch eine Verschweißung (z.B. Elektronenstrahlverschweißung).

Darüber sieht auch das erfindungsgemäße Herstellungsverfahren in Übereinstimmung mit dem bekannten Herstellungsverfahren gemäß EP 0 605 800 A1 vor, dass das Verbundmaterialband gestanzt wird, so dass von dem Verbundmaterialband ein Stanzteil übrig bleibt, wobei das Stanzteil mindestens einen Widerstand mit einem Widerstandselement aus dem Widerstandsmaterial und zwei Stromanschlussteile aus dem Leitermaterial aufweist.

Das erfindungsgemäße Herstellungsverfahren zeichnet sich nun dadurch aus, dass das Stanzteil auch mindestens eine Landefläche aufweist zur Bestückung mit einer integrierten Schaltung auf der Landefläche des Stanzteils.

Darüber umfasst das Stanzteil bei dem erfindungsgemäßen Herstellungsverfahren vorzugsweise auch zwei Spannungsmesskontakte und/oder mehrere elektrische Außenkontakte zur elektrischen Kontaktierung der integrierten Schaltung.

Nach dem Ausstanzen des Stanzteils aus dem Verbundmaterial wird die Landefläche auf dem Stanzteil dann vorzugsweise mit einer integrierten Schaltung bestückt.

Anschließend wird die integrierte Schaltung dann durch Bondverbindungen mit den Außenkontakten und mit den Spannungsmesskontakten verbunden.

In einem weiteren Verfahrensschritt erfolgt dann vorzugsweise ein Ummanteln des Widerstands, der integrierten Schaltung und der Bondverbindungen mit einer Ummantelung aus einem Kunststoff, wobei die Außenkontakte der integrierten Schaltung und die Stromanschlussteile des Widerstands aus der Ummantelung herausragen.

In einem weiteren Arbeitsschritt sieht das erfindungsgemäße Herstellungsverfahren dann noch vor, dass einzelne Stromsensoren von dem Verbundmaterialband vereinzelt werden, indem die einzelnen Stromsensoren quer zur Bandlängsrichtung des Verbundmaterialbands abgetrennt werden.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1: eine Perspektivansicht eines herkömmlichen Verbundmaterialbands, das auch im Rahmen der Erfindung eingesetzt wird,
- Figur 2A: eine Perspektivansicht eines erfindungsgemäßen Stanzteils, das aus dem Verbundmaterialband gemäß Figur 1 ausgestanzt ist und zur Herstellung zahlreicher Stromsensoren dient,
- Figur 2B: eine vergrößerte Detaildarstellung von Figur 2A im Bereich eines Stromsensors,
- Figur 3A: eine Perspektivansicht des Stanzteils aus Figur 2A, wobei auf die Landeflächen jeweils integrierte Schaltungen aufgesetzt sind, die durch Bondverbindungen mit den Anschlussteilen und mit den Spannungsmesskontakten verbunden sind,
- Figur 3B: eine vergrößerte Detaildarstellung aus Figur 3A im Bereich eines einzigen Stromsensors,
- Figur 4: eine Perspektivansicht des Stanzteils aus Figur 3A, wobei die einzelnen Stromsensoren bereits ummantelt sind,
- Figur 5: eine Perspektivansicht eines fertigen Stromsensors, der aus dem Stanzteils gemäß Figur 4 abgetrennt ist,
- Figur 6: das erfindungsgemäße Herstellungsverfahren in Form eines Flussdiagramms, sowie
- Figur 7: eine schematische Darstellung eines Strommesswiderstands, wie er im Rahmen der Erfindung eingesetzt wird.

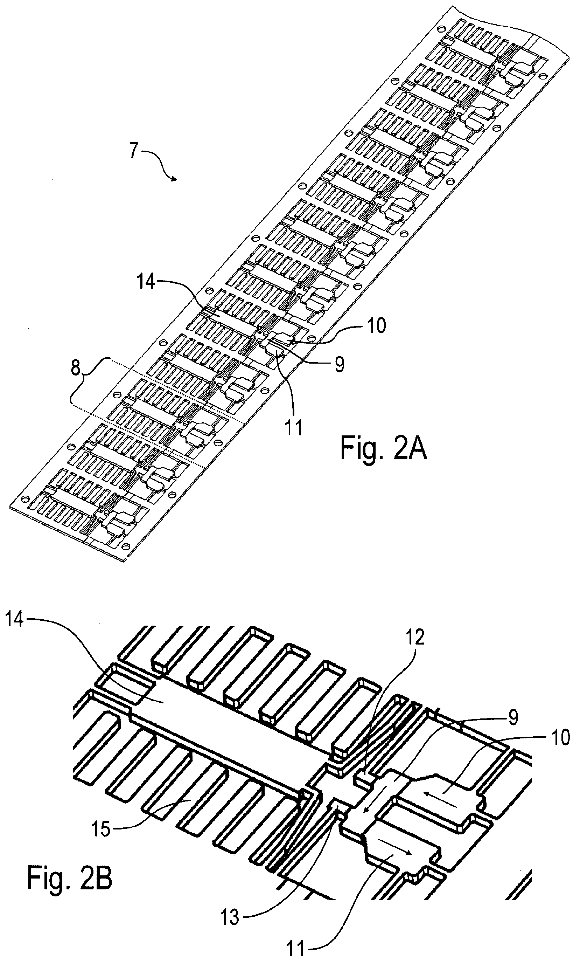

Die Figuren 2A und 2B zeigen ein bevorzugtes Ausführungsbeispiel eines erfindungsgemäßen Stanzteils 7, das aus dem Verbundmaterialband 1 gemäß Figur 1 ausgestanzt werden kann, wobei das Stanzteil 7 in Bandlängsrichtung hintereinander zahlreiche Rohlinge 8 aufweist, die nach weiteren Bearbeitungsschritten jeweils einen Stromsensor bilden sollen.

Die einzelnen Rohlinge 8 des Stanzteils 7 weisen jeweils ein Widerstandselement 9 auf, das aus dem Material des mittleren Bands 4 besteht, so dass das Widerstandselement 9 aus dem Widerstandsmaterial (z.B. Manganin®) des Bandes 4 besteht.

Weiterhin umfasst jeder Rohling 8 des Stanzteils 7 zwei Stromanschlussteile 10, 11 zur Einleitung des zu messenden Stroms bzw. zum Ausleiten des zu messenden elektrischen Stroms. Die beiden Stromanschlussteile 10, 11 bestehen hierbei aus dem Material des Bandes 3 aus dem Leitermaterial (z.B. Kupfer), so dass die beiden Stromanschlussteile 10,11 auch aus dem Leitermaterial bestehen.

Hierbei ist zu erwähnen, dass die beiden Stromanschlussteile 10, 11 herstellungsbedingt auf derselben Seite des Widerstandselements 9 angeordnet sind, so dass Einleitung bzw. Ausleitung des elektrischen Stroms von derselben Seite des Widerstandselements 9 erfolgen. Das Stromanschlussteil 10 dient hierbei zum Einleiten des elektrischen Stroms in das Widerstandselement 9, während das Stromanschlussteil 11 zum Ausleiten des elektrischen Stroms aus dem Widerstandselement 9 dient.

Weiterhin umfasst jeder Rohling 8 des Stanzteils 7 zwei Spannungsmesskontakte 12, 13 zur Messung der über dem Widerstandselement 9 abfallenden elektrischen Spannung. Diese gemessene Spannung ist proportional zu dem durch das Widerstandselement 9 fließenden elektrischen Strom und bildet deshalb gemäß dem Ohmschen Gesetz ein Maß für den zu messenden elektrischen Strom.

Ferner weist jeder Rohling 8 des Stanzteils 7 eine Landefläche 14 auf, die mit einer integrierten Schaltung bestückt werden kann, wie noch detailliert beschrieben wird.

Schließlich umfasst jeder Rohling 8 des Stanzteils 7 mehrere elektrische Außenkontakte 15 zur elektrischen Kontaktierung der auf der Landefläche 14 angeordneten integrierten Schaltung, wobei die Verbindung zwischen den Außenkontakten 15 und der integrierten Schaltung noch detailliert beschrieben wird. Die einzelnen Außenkontakte 15 sind hierbei durch eine Ausstanzung von der Landefläche 14 und von den Spannungsmesskontakten 12, 13 getrennt.

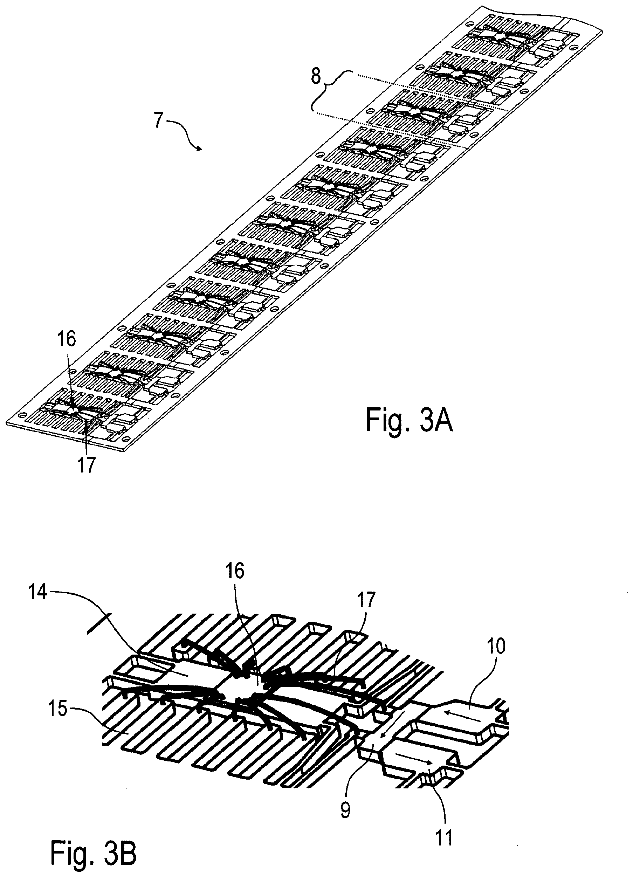

Die Figuren 3A und 3B zeigen ein fortgeschrittenes Verfahrensstadium des erfindungsgemäßen Herstellungsverfahrens.

In diesem Verfahrensstadium sind die einzelnen Landeflächen 14 der einzelnen Rohlinge 8 bereits mit jeweils einer integrierten Schaltung 16 bestückt, und die Anschlusskontakte der integrierten Schaltung 16 sind durch Bondverbindungen 17 mit den zugehörigen Außenkontakten 15 verbunden.

Darüber hinaus sind auch die Spannungsmesskontakte 12, 13 durch Bondverbindungen 17 mit der integrierten Schaltung 16 verbunden, so dass die integrierte Schaltung 16 über die Spannungsmesskontakte 12, 13 die über dem Widerstandselement 9 abfallende elektrische Spannung messen kann.

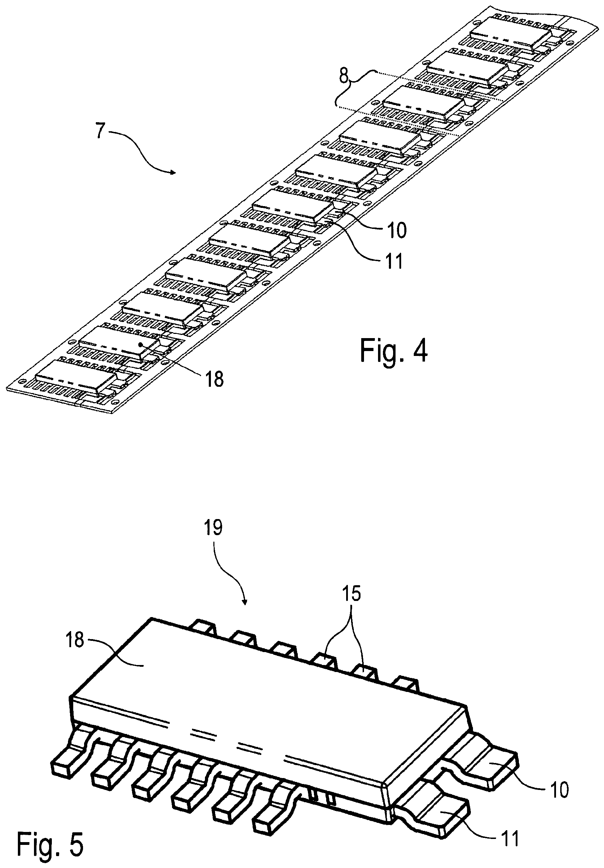

Die Figur 4 zeigt ein noch weiter fortgeschrittenes Verfahrensstadium des erfindungsgemäßen Herstellungsverfahrens. In diesem Verfahrensstadium sind die einzelnen Rohlinge 8 des Stanzteils 7 jeweils mit einer Ummantelung 18 aus Duroplast umspritzt, wobei aus der Ummantelung 18 zum einen die Stromanschlussteile 10, 11 und zum anderen die Außenkontakte 15 herausragen.

Figur 5 zeigt schließlich einen erfindungsgemäßen Stromsensor 19, der aus dem Stanzteil 7 gemäß Figur 4 abgetrennt ist. Die Vereinzelung der einzelnen Stromsensoren 19 von dem Stanzteil 7 gemäß Figur 4 kann beispielsweise durch Ausstanzen oder durch ein sonstiges Trennverfahren erfolgen.

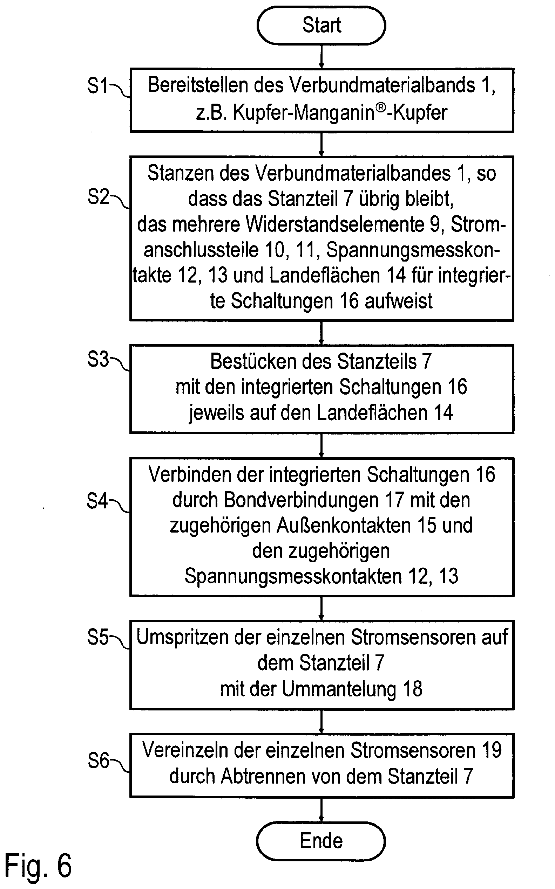

Figur 6 zeigt das erfindungsgemäße Herstellungsverfahren in Form eines Flussdiagramms.

In einem ersten Schritt S1 wird zunächst das herkömmliche Verbundmaterialband 1 bereitgestellt, wie es beispielsweise in Figur 1 dargestellt ist. Allerdings ist hierbei zu bemerken, dass das Band 2 eine größere Breite aufweist als das Band 3, da das Band 2 auch die Landefläche 14 für die integrierte Schaltung 16 bilden muss, was eine größere Breite erfordert.

In einem weiteren Schritt S2 wird das Verbundmaterialband 1 dann gestanzt, so dass das Stanzteil 7 gemäß Figur 2A übrig bleibt.

In nächsten Schritt S3 wird das Stanzteil 7 gemäß Figur 2A dann mit den integrierten Schaltungen 16 bestückt.

In einem weiteren Schritt S4 werden die integrierten Schaltungen 16 dann durch die Bondverbindungen 17 mit den Außenkontakten 15 bzw. mit den Spannungsmesskontakten 12, 13 verbunden, wie es in Figur 3A dargestellt ist.

In einem Schritt S5 werden die einzelnen Stromsensoren 19 dann mit der Ummantelung 18 aus dem Duroplast umspritzt, wie es in Figur 4 dargestellt ist.

Im letzten Schritt S6 werden dann die einzelnen Stromsensoren 19 vereinzelt, indem die einzelnen Stromsensoren 19 von dem Stanzteil 7 abgetrennt werden.

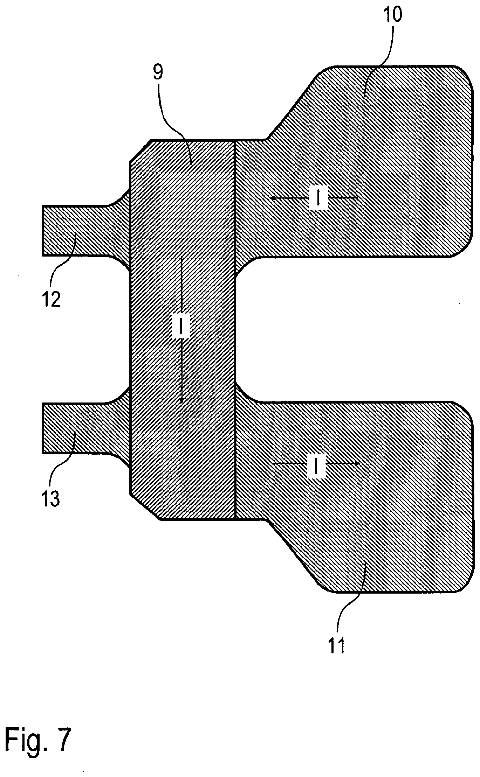

Schließlich zeigt Figur 7 noch die Stromflussrichtung in den Stromanschlussteilen 10, 11 und in dem Widerstandselement 9 sowie die Position der Spannungsmesskontakte 12, 13. Aus dieser Darstellung ist ersichtlich, dass die Stromanschlussteile 10, 11 auf der einen Seite des Widerstandselements 9 angeordnet sind, während sich die Spannungsmesskontakte 12, 13 auf der gegenüberliegenden Seite des Widerstandselements 9 befinden.

Die Erfindung ist nicht auf die vorstehend beschriebenen bevorzugten Ausführungsbeispiele beschränkt. Vielmehr ist eine Vielzahl von Varianten und Abwandlungen möglich, gemäß den angehängten Ansprüchen, die deshalb in den Schutzbereich fallen.

### Bezugszeichenliste:

- 1: Verbundmaterialband
- 2: Band aus Leitermaterial
- 3: Band aus Leitermaterial
- 4: Band aus Widerstandsmaterial
- 5: Längskante des Bands aus dem Widerstandsmaterial
- 6: Längskante des Bands aus dem Widerstandsmaterial
- 7: Stanzteil
- 8: Rohling
- 9: Widerstandselement
- 10: Stromanschlussteil
- 11: Stromanschlussteil
- 12: Spannungsmesskontakt
- 13: Spannungsmesskontakt
- 14: Landefläche für die integrierte Schaltung
- 15: Außenkontakte der integrierten Schaltung
- 16: Integrierte Schaltung
- 17: Bondverbindungen
- 18: Ummantelung
- 19: Stromsensor

## Patentansprüche

1. Stanzteil (7) als nicht vereinzelter Rohling zur Herstellung einer Vielzahl von elektrischen Widerständen, insbesondere von Strommesswiderständen, durch Abtrennung der einzelnen Widerstände von dem Rohling, wobei der Rohling eine Vielzahl von abzutrennenden Widerständen umfasst und die einzelnen Widerstände jeweils folgendes aufweisen:
a) ein Widerstandselement (9) aus einem niederohmigen Widerstandsmaterial,
b) ein erstes Stromanschlussteil (10) aus einem Leitermaterial zum Einleiten eines elektrischen Stroms (I) in den Widerstand und
c) ein zweites Stromanschlussteil (11) aus einem Leitermaterial zum Ausleiten des elektrischen Stroms (I) aus dem Widerstand,
d) wobei das Widerstandselement (9) in Stromflussrichtung zwischen dem ersten Stromanschlussteil (10) und dem zweiten Stromanschlussteil (11) angeordnet ist, so dass der elektrische Strom (I) durch das Widerstandselement (9) fließt,
e) wobei das Stanzteil (7) aus einem Verbundmaterialband (1) ausgestanzt ist,
f) wobei das Leitermaterial einen kleineren spezifischen elektrischen Widerstand aufweist als das Widerstandsmaterial,
**dadurch gekennzeichnet,**
g) dass die einzelnen Widerstände jeweils eine Landefläche (14) aufweisen zur Bestückung mit einer integrierten Schaltung (16) auf der Landefläche (14) des Stanzteils (7).

2. Stanzteil (7) nach Anspruch 1, **gekennzeichnet durch** einen ersten Spannungsmesskontakt (12) und einen zweiten Spannungsmesskontakt (13) zur Messung der über dem Widerstandselement (9) abfallenden elektrischen Spannung.

3. Stanzteil (7) nach einem der vorhergehenden Ansprüche, **gekennzeichnet durch** mehrere elektrische Außenkontakte (15) zur elektrischen Kontaktierung der integrierten Schaltung (16) von außen.

4. Stanzteil (7) nach einem der vorhergehenden Ansprüche, **dadurch gekennzeichnet,**
a) **dass** die Außenkontakte (15) durch eine Ausstanzung von der Landefläche (14) für die integrierte Schaltung (16) und/oder von den Spannungsmesskontakten (12, 13) getrennt sind, und
b) **dass** die Spannungsmesskontakte (12, 13) einerseits und die Stromanschlussteile (10, 11) andererseits auf gegenüber liegenden Seiten des Widerstandselements (9) angeordnet sind, und
c) **dass** die beiden Stromanschlussteile (10, 11) bezüglich der Stromflussrichtung in dem Widerstandselement (9) seitlich an das Widerstandselement (9) angrenzen, insbesondere auf derselben Seite des Widerstandselements (9).

5. Stanzteil (7) nach einem der vorhergehenden Ansprüche, **dadurch gekennzeichnet,**
a) **dass** das Verbundmaterialband (1) aus mehreren Bändern (2, 3, 4) besteht, die entlang ihrer Längskanten (5, 6) miteinander verbunden sind, und
b) **dass** die einzelnen Bänder (2, 3, 4) des Verbundmaterialbands (1) miteinander verschweißt sind, insbesondere durch eine Elektronenstrahlverschweißung, und
c) **dass** das Verbundmaterialband (1) ein mittleres Band (4) und zwei äußere Bänder (2, 3) aufweist, wobei die äußeren Bänder (2, 3) aus dem Leitermaterial bestehen, während das mittlere Band (4) aus dem Widerstandsmaterial besteht, und
d) **dass** die Stromflussrichtung in dem Widerstandselement (9) parallel zur Bandlängsrichtung des Verbundmaterialbands (1) verläuft.

6. Stanzteil (7) nach einem der vorhergehenden Ansprüche, **dadurch gekennzeichnet,**
a) **dass** das Leitermaterial der Stromanschlussteile (10, 11) Kupfer oder eine Kupferlegierung ist, und
b) **dass** das Widerstandsmaterial des Widerstandselements (9) eine Kupferlegierung ist, insbesondere eine Kupfer-Mangan-Nickel-Legierung, insbesondere Cu84Ni4Mn12, oder eine Nickellegierung ist, insbesondere NiCr oder CuNi, und/oder
c) **dass** das Widerstandselement (9) elektrisch und mechanisch mit den beiden Stromanschlussteilen (10, 11) verbunden ist, insbesondere durch eine Schweißverbindung, und
d) **dass** die Stromanschlussteile (10, 11) und das Widerstandselement (9) plattenförmig sind, und
e) **dass** die plattenförmigen Stromanschlussteile (10, 11) und/oder das plattenförmige Widerstandselement (9) eben oder gebogen sind, und
f) **dass** das Widerstandsmaterial einen spezifischen elektrischen Widerstand mit einem Temperaturkoeffizienten von weniger als 5·10⁻⁴K⁻¹, 2·10⁻⁴K⁻¹, 1·10⁻⁴K⁻¹ oder 5.10⁻⁵K⁻¹ aufweist, und
g) **dass** das Widerstandsmaterial einen spezifischen elektrischen Widerstand aufweist, der kleiner ist als 2·10⁻⁴ Ω·m, 2·10⁻⁵ Ω·m oder 2·0⁻⁶ Ω·m, und
h) **dass** das Leitermaterial einen spezifischen elektrischen Widerstand aufweist, der kleiner ist als 10⁻⁵ Ω·m, 10⁻⁶ Ω·m oder 10⁻⁷ Ω·m.

7. Stromsensor (19), **gekennzeichnet durch**
a) einen Widerstand, der aus dem Stanzteil (7) nach einem der vorhergehenden Ansprüche abgetrennt ist, und
b) mindestens eine integrierte Schaltung (16), die auf der Landefläche (14) des Stanzteils (7) montiert ist.

8. Stromsensor (19) nach Anspruch 7, **gekennzeichnet durch**
a) eine erste integrierte Schaltung (16), die durch Bondverbindungen mit den Spannungsmesskontakten (12, 13) verbunden ist, um die über dem Widerstandselement (9) abfallende elektrische Spannung zu messen,
b) eine zweite integrierte Schaltung, und
c) eine galvanische Trennung zwischen der zweiten integrierten Schaltung und den Spannungsmesskontakten (12, 13), insbesondere durch eine kapazitive, induktive oder optische Kopplung.

9. Stromsensor (19) nach einem der Ansprüche 7 bis 8, **dadurch gekennzeichnet,**
a) **dass** der Stromsensor (19) eine Ausgangsschaltung aufweist, insbesondere in der zweiten integrierten Schaltung, wobei die Ausgangsschaltung ein Ausgangssignal ausgibt, das die über dem Widerstandselement (9) abfallende elektrische Spannung wiedergibt, insbesondere in digitaler Form, und
b) **dass** die Ausgangsschaltung einen Sigma-Delta-Modulator enthält, der als Ausgangssignal einen 1-Bit-datenstrom ausgibt.

10. Stromsensor (19) nach einem der Ansprüche 7 bis 9, **dadurch gekennzeichnet, dass** die integrierte Schaltung (16) durch Bondverbindungen (17) mit den Außenkontakten (15) und mit den Spannungsmesskontakten (12, 13) verbunden ist.

11. Stromsensor (19) nach einem der Ansprüche 8 bis 10, **gekennzeichnet durch** eine elektrisch isolierende Ummantelung (18), welche die integrierte Schaltung (16), die Bondverbindungen (17) und den Widerstand (9) umgibt, wobei die Außenkontakte (15) der integrierten Schaltung (16) und die Stromanschlussteile (10, 11) des Widerstands aus der Ummantelung herausragen.

12. Stromsensor (19) nach Anspruch 11,
**dadurch gekennzeichnet,**
a) **dass** die Ummantelung (18) aus einem Kunststoff besteht, insbesondere aus einem Duroplast, und
b) **dass** die integrierte Schaltung (16), die Bondverbindungen (17) und der Widerstand mit dem Kunststoff der Ummantelung (18) umspritzt sind.

13. Herstellungsverfahren zur Herstellung eines Stromsensors (19), mit den folgenden Schritten:
a) Bereitstellen eines Verbundmaterialbands (1), das zwei äußere Bänder (2, 3) aus einem Leitermaterial und ein mittleres Band (4) aus einem Widerstandsmaterial aufweist, wobei die Bänder (2, 3, 4) entlang ihrer Längskanten (5, 6) elektrisch und mechanisch miteinander verbunden sind, insbesondere durch eine Verschweißung, wobei das Leitermaterial einen kleineren spezifischen elektrischen Widerstand aufweist als das Widerstandsmaterial,
b) Stanzen des Verbundmaterialbands (1), so dass von dem Verbundmaterialband (1) ein Stanzteil (7) als Rohling übrig bleibt, wobei das Stanzteil (7) eine Vielzahl von Widerständen mit jeweils einem Widerstandselement (9) aus dem Widerstandsmaterial und jeweils zwei Stromanschlussteilen (10, 11) aus dem Leitermaterial aufweist,
**dadurch gekennzeichnet,**
c) dass das Stanzteil (7) für jeden Widerstand jeweils auch mindestens eine Landefläche (14) aufweist zur Bestückung mit einer integrierten Schaltung auf der Landefläche (14) des Stanzteils (7).

14. Herstellungsverfahren nach Anspruch 13,
**dadurch gekennzeichnet,**
a) **dass** das Stanzteil (7) auch zwei Spannungsmesskontakte (12, 13) aufweist zur Messung der über dem Widerstandselement (9) abfallenden elektrischen Spannung, und
b) **dass** das Stanzteil (7) auch mehrere elektrische Außenkontakte (15) aufweist zur elektrischen Kontaktierung der integrierten Schaltung von außen.

15. Herstellungsverfahren nach Anspruch 14,
**gekennzeichnet durch** folgende Schritte:
a) Bestücken der Landefläche (14) auf dem Stanzteil (7) mit der integrierten Schaltung (16), und
b) Elektrisches Verbinden der integrierten Schaltung (16) durch Bondverbindungen (17) mit den Außenkontakten (15) und mit den Spannungsmesskontakten (12, 13), und
c) Ummanteln des Widerstands, der integrierten Schaltung (16) und der Bondverbindungen (17) mit einer Ummantelung (18) aus einem Kunststoff, wobei die Außenkontakte (15) der integrierten Schaltung (16) und die Stromanschlussteile (10, 11) des Widerstands aus der Ummantelung (18) herausragen, und
d) Vereinzeln von Stromsensoren (19) durch Abtrennen quer zur Bandlängsrichtung des Stanzteils (7).

## Claims

1. Punched part (7) in the form of a non-separated blank for producing a plurality of electrical resistors, in particular current sense resistors, by separating the individual resistors from the blank, wherein the blank comprises a plurality of resistors to be separated and the individual resistors each have the following:
a) a resistor element (9) made of a low-resistance resistive material,
b) a first current connection part (10) made of a conductor material for introducing an electric current (I) into the resistor, and
c) a second current connection part (11) made of a conductor material for discharging the electric current (I) from the resistor,
d) wherein the resistor element (9) is disposed in current flow direction between the first current connection part (10) and the second current connection part (11) so that the electric current (I) flows through the resistor element (9),
e) the punched part (7) being punched out of a composite material strip (1),
f) said conductor material having a lower resistivity than said resistive material,
**characterized in that**
g) the individual resistors each have a landing surface (14) for equipping with an integrated circuit (16) on the landing surface (14) of the punched part (7).

2. Punched part (7) according to claim 1, **characterized by** a first voltage measuring contact (12) and a second voltage measuring contact (13) for measuring the electrical voltage falling across the resistor element (9).

3. Punched part (7) according to one of the preceding claims, **characterized by** a plurality of electrical external contacts (15) for making electrical contact with the integrated circuit (16) from the outside.

4. Punched part (7) according to one of the preceding claims, **characterized in that**
a) the external contacts (15) are separated from the landing surface (14) for the integrated circuit (16) and/or from the voltage measuring contacts (12, 13) by a punch-out, and
b) **in that** the voltage measuring contacts (12, 13) on the one hand and the current connection parts (10, 11) on the other hand are arranged on opposite sides of the resistor element (9), and
c) **in that** the two current connection parts (10, 11) adjoin the resistor element (9) laterally with respect to the current flow direction in the resistor element (9), in particular on the same side of the resistor element (9).

5. Punched part (7) according to one of the preceding claims, **characterized in that**
a) the composite material strip (1) consists of a plurality of strips (2, 3, 4) which are connected to one another along their longitudinal edges (5, 6), and
b) the individual strips (2, 3, 4) of the composite material strip (1) are welded together, in particular by electron beam welding, and
c) **in that** the composite material strip (1) has a central strip (4) and two outer strips (2, 3), the outer strips (2, 3) being composed of the conductor material, while the central strip (4) is composed of the resistive material, and
d) **in that** the current flow direction in the resistor element (9) runs parallel to the longitudinal direction of the strip of composite material (1).

6. Punched part (7) according to one of the preceding claims, **characterized in that**
a) the conductor material of the current connection parts (10, 11) is copper or a copper alloy, and
b) **in that** the resistance material of the resistor element (9) is a copper alloy, in particular a copper-manganese-nickel alloy, in particular Cu84Ni4Mn12, or a nickel alloy, in particular NiCr or CuNi, and/or
c) **in that** the resistor element (9) is electrically and mechanically connected to the two current connection parts (10, 11), in particular by a welded connection, and
d) **in that** the current connection parts (10, 11) and the resistor element (9) are plate-shaped, and
e) **in that** the plate-shaped current connection parts (10, 11) and/or the plate-shaped resistor element (9) are flat or curved, and
f) the resistive material has a resistivity with a temperature coefficient of less than 5·10⁻⁴K⁻¹, 2·10⁻⁴ K⁻¹, 1·10⁻⁴K⁻¹ or 5·10⁻⁵K⁻¹, and
g) said resistive material has a resistivity of less than 2·10⁻⁴ Ω·m, 2·10⁻⁵ Ω·m or 2·10⁻⁶ Ω·m; and
h) the conductor material has a resistivity of less than 10⁻⁵ Ω·m, 10⁻⁶ Ω·m or 10⁻⁷ Ω·m.

7. Current sensor (19), **characterized by**
a) a resistor separated from the punched part (7) according to one of the preceding claims; and
b) at least one integrated circuit (16) which is mounted on the landing surface (14) of the punched part (7).

8. Current sensor (19) according to claim 7,
**characterized by**
a) a first integrated circuit (16) connected by bond connections to the voltage measuring contacts (12, 13) for measuring the electrical voltage dropping across the resistor element (9),
b) a second integrated circuit; and
c) a galvanic separation between the second integrated circuit and the voltage measuring contacts (12, 13), in particular by a capacitive, inductive or optical coupling.

9. Current sensor (19) according to any of claims 7 to 8, **characterized in that**
a) the current sensor (19) has an output circuit, in particular in the second integrated circuit, the output circuit outputting an output signal which reproduces the electrical voltage which drops across the resistor element (9), in particular in digital form, and
b) **in that** the output circuit contains a sigma-delta modulator which outputs a 1-bit data stream as an output signal.

10. Current sensor (19) according to one of claims 7 to 9, **characterized in that** the integrated circuit (16) is connected by bond connections (17) to the external contacts (15) and to the voltage measuring contacts (12, 13).

11. Current sensor (19) according to any of claims 8 to 10, **characterized by** an electrically insulating sheath (18) surrounding the integrated circuit (16), the bond connections (17) and the resistor (9), wherein the outer contacts (15) of the integrated circuit (16) and the current connection parts (10, 11) of the resistor protrude from the sheath.

12. Current sensor (19) according to claim 11,
**characterized in that**
a) the sheath (18) consists of a plastics material, in particular of a thermosetting plastic, and
b) **in that** the integrated circuit (16), the bond connections (17) and the resistor are encapsulated with the plastic of the sheath (18).

13. Manufacturing method for manufacturing a current sensor (19), comprising the following steps:
a) providing a composite material strip (1) comprising two outer strips (2, 3) of a conductor material and a middle strip (4) of a resistor material, the strips (2, 3, 4) being electrically and mechanically connected together along their longitudinal edges (5, 6), in particular by welding, the conductor material having a lower specific electrical resistance than the resistor material,
b) punching the composite material strip (1) so that a punched part (7) remains as a blank of the composite material strip (1), wherein the punched part (7) comprises a plurality of resistors each having a resistor element (9) made of the resistive material and each having two current connection parts (10, 11) made of the conductor material,
**characterized in that**
c) the punched part (7) in each case also has at least one landing surface (14) for each resistor for equipping with an integrated circuit on the landing surface (14) of the punched part (7).

14. Manufacturing process according to claim 13,
**characterized in that**
a) the punched part (7) also has two voltage measuring contacts (12, 13) for measuring the electrical voltage which drops across the resistor element (9), and
b) **in that** the punched part (7) also has a plurality of electrical external contacts (15) for making electrical contact with the integrated circuit from the outside.

15. Manufacturing process according to claim 14,
**characterized by** the following steps:
a) equipping the landing surface (14) on the punched part (7) with the integrated circuit (16), and
b) electrically connecting said integrated circuit (16) by bond connections (17) to said outer contacts (15) and to said voltage measuring contacts (12, 13); and
c) sheathing the resistor, the integrated circuit (16) and the bond connections (17) with a sheath (18) made of a plastic, the outer contacts (15) of the integrated circuit (16) and the current connection parts (10, 11) of the resistor protruding from the sheath (18), and
d) separating current sensors (19) by separating them transversely to the longitudinal direction of the strip of the punched part (7).

## Revendications

1. Pièce estampée (7) en tant qu'ébauche non séparée pour la fabrication d'une pluralité de résistances électriques, plus particulièrement de résistances de mesure de courant, par la séparation des différentes résistances de l'ébauche, l'ébauche comprenant une pluralité de résistances à séparer et les différentes résistances comprenant chacune ce qui suit :
a) un élément de résistance (9) constitué d'un matériau à faible valeur ohmique,
b) un premier élément de raccordement électrique (10) constitué d'un matériau conducteur pour l'introduction d'un courant électrique (I) dans la résistance et
c) un deuxième élément de raccordement électrique (11) constitué d'un matériau conducteur pour l'évacuation du courant électrique (I) hors de la résistance,
d) l'élément de résistance (9) étant disposé, dans la direction du flux de courant, entre le premier élément de raccordement électrique (10) et le deuxième élément de raccordement électrique (11), de façon à ce que le courant électrique (I) s'écoule à travers l'élément de résistance (9),
e) la pièce estampée (7) étant estampée à partir d'une bande de matériau composite (1),
f) le matériau conducteur présentant une résistance électrique spécifique inférieure à celle du matériau de la résistance,
**caractérisée en ce que**
g) les différentes résistances comprennent chacune une surface de pose (14) pour l'équipement avec un circuit intégré (16) sur la surface de pose (14) de la pièce estampée (7).

2. Pièce estampée (7) selon la revendication 1, **caractérisée par** un premier contact de mesure de tension (12) et un deuxième contact de mesure de tension (13) pour la mesure de la tension électrique aux bornes de l'élément de résistance (9).

3. Pièce estampée (7) selon l'une des revendications précédentes, **caractérisée par** plusieurs contacts électriques externes (15) pour la mise en contact électrique du circuit intégré (16) de l'extérieur.

4. Pièce estampée (7) selon l'une des revendications précédentes, **caractérisée en ce que**
a) les contacts externes (15) sont séparés, par un estampage de la surface de pose (14) pour le circuit intégré (16) et/ou des contacts de mesure de tension (12, 13) et
b) les contacts de mesure de tension (12, 13) d'une part et les éléments de raccordement électrique (10, 11) d'autre part sont disposés sur des côtés opposés de l'élément de résistance (9) et
c) les deux éléments de raccordement électrique (10, 11) sont adjacents latéralement à l'élément de résistance (9), par rapport à la direction d'écoulement du courant dans l'élément de résistance (9), plus particulièrement sur le même côté de l'élément de résistance (9).

5. Pièce estampée (7) selon l'une des revendications précédentes, **caractérisée en ce que**
a) la bande de matériau composite (1) est constituée de plusieurs bandes (2, 3, 4) qui sont reliées entre elles le long de leurs arêtes longitudinales (5, 6) et
b) les différentes bandes (2, 3, 4) de la bande de matériau composite (1) sont soudées entre elles, plus particulièrement à l'aide d'une soudure par faisceau d'électrons et
c) la bande de matériau composite (1) comprend une bande centrale (4) et deux bandes externes (2, 3), les bandes externes (2, 3) étant constituée du matériau conducteur tandis que la bande centrale (4) est constituée du matériau de résistance et
d) la direction d'écoulement du courant dans l'élément de résistance (9) s'étend parallèlement à la direction longitudinale de la bande de matériau composite (1).

6. Pièce estampée (7) selon l'une des revendications précédentes, **caractérisée en ce que**
a) le matériau conducteur des éléments de raccordement électrique (10, 11) est du cuivre ou un alliage de cuivre et
b) le matériau de résistance de l'élément de résistance (9) est un alliage de cuivre, plus particulièrement du Cu84Ni4Mn12 ou un alliage de nickel, plus particulièrement du NiCr ou du CuNi et/ou
c) l'élément de résistance (9) est relié électriquement et mécaniquement avec les deux éléments de raccordement électrique (10, 11), plus particulièrement à l'aide d'une liaison soudée et
d) les éléments de raccordement électrique (10, 11) et l'élément de résistance (9) présentent la forme de plaques et
e) les éléments de raccordement électrique (10, 11) en forme de plaques et/ou l'élément de résistance (9) en forme de plaque sont plats ou courbés et
f) le matériau de résistance présente une résistance électrique spécifique avec un coefficient de température inférieur à 5.10⁻⁴ K⁻¹, 2.10⁻⁴ K⁻¹, 1.10⁻⁴ K⁻¹ ou 5.10⁻⁵ K⁻¹ et
g) le matériau de résistance présente une résistance électrique spécifique qui est inférieure à 2.10⁻⁴ Ω.m, 2.10⁻⁵ Q.m ou 2.10⁻⁶ Ω.m et
h) le matériau conducteur présente une résistance électrique spécifique qui est inférieure à 10⁻⁵ Ω.m, 10⁻⁶ Ω.m ou 10⁻⁷Ω.m.

7. Capteur de courant (19) **caractérisé par**
a) une résistance qui est séparée de la pièce estampée (7) selon l'une des revendications précédentes et
b) au moins un circuit intégré (16) qui est monté sur la surface de pose (14) de la pièce estampée (7).

8. Capteur de courant (19) selon la revendication 7, **caractérisé par**
a) un premier circuit intégré (16) qui est relié à l'aide de liaisons avec les contacts de mesure de tension (12, 13), afin de mesurer la tension électrique aux bornes de l'élément de résistance (9),
b) un deuxième circuit intégré et
c) une séparation galvanique entre le deuxième circuit intégré et les contacts de mesure de tension (12, 13), plus particulièrement à l'aide d'un couplage capacitif, inductif ou optique.

9. Capteur de courant (19) selon l'une des revendications 7 à 8, **caractérisé en ce que**
a) le capteur de courant (19) comprend un circuit de sortie, plus particulièrement dans le deuxième circuit intégré, le circuit de sortie émettant un signal de sortie qui reproduit la tension électrique aux bornes de l'élément de résistance (9), plus particulièrement sous forme numérique et
b) le circuit de sortie contient un modulateur sigma-delta qui émet, en tant que signal de sortie, un flux de données de 1 bit.

10. Capteur de courant (19) selon l'une des revendications 7 à 9, **caractérisé en ce que** le circuit intégré (16) est relié par des liaisons (17) avec les contacts externes (15) et avec les contacts de mesure de tension (12, 13).

11. Capteur de courant (19) selon l'une des revendications 8 à 10, **caractérisé par** une enveloppe électriquement isolante (18) qui entoure le circuit intégré (16), les liaisons (17) et la résistance (9), les contacts externes (15) du circuit intégré (16) et les éléments de raccordement électrique (10, 11) de la résistance dépassant de l'enveloppe.

12. Capteur de courant (19) selon la revendication 11,
**caractérisé en ce que**
a) l'enveloppe (18) est constituée d'une matière plastique, plus particulièrement d'une matière plastique thermodurcissable et
b) le circuit intégré (16), les liaisons (17) et la résistance sont surmoulés avec la matière plastique de l'enveloppe (18).

13. Procédé de fabrication pour la fabrication d'un capteur de courant (19), avec les étapes suivantes :
a) préparation d'une bande de matériau composite (1), qui comprend deux bandes externes (2, 3) constituées d'un matériau conducteur et une bande centrale (4) constituée d'un matériau de résistance, les bandes (2, 3, 4) étant reliées électriquement et mécaniquement entre elles le long de leurs arêtes longitudinales (5, 6), plus particulièrement à l'aide d'une soudure, le matériau conducteur présentant une résistance électrique spécifique inférieure à celle du matériau de résistance,
b) estampage de la bande de matériau composite (1) de façon à ce que, de la bande de matériau composite (1), il subsiste une pièce estampée (7) en tant qu'ébauche, la pièce estampée (7) comprenant une pluralité de résistances avec chacune un élément de résistance (9) en matériau de résistance et chacune deux éléments de raccordement électrique (10, 11) en matériau conducteur,
**caractérisé en ce que**
c) la pièce estampée (7) comprend, pour chaque résistance, également au moins une surface de pose (14) pour l'équipement avec un circuit intégré sur la surface de pose (14) de la pièce estampée (7).

14. Procédé de fabrication selon la revendication 13,
**caractérisé en ce que**
a) la pièce estampée (7) comprend également deux contacts de mesure de tension (12, 13) pour la mesure de la tension aux bornes de l'élément de résistance (9) et
b) la pièce estampée (7) comprend également plusieurs contacts électriques externes (15) pour la mise en contact électrique du circuit intégré de l'extérieur.

15. Procédé de fabrication selon la revendication 14,
**caractérisé par** les étapes suivantes :
a) équipement de la surface de pose (14) sur la pièce estampée (7) avec le circuit intégré (16) et
b) liaison électrique du circuit intégré (16) par des liaisons (17) avec les contacts externes (15) et avec les contacts de mesure de tension (12, 13) et
c) enveloppement de la résistance, du circuit intégré (16) et des liaisons (17) avec une enveloppe (18) en matière plastique, les contacts externes (15) du circuit intégré (16) et les éléments de raccordement électrique (10, 11) de la résistance dépassant de l'enveloppe (18) et
d) séparation des capteurs de courant (19) par découpage transversalement par rapport à la direction longitudinale de la bande de la pièce estampée (7).
